# EUROPÄISCHE PATENTSCHRIFT

(11) **EP 1 587 140 B1**
(45) Veröffentlichungstag und Bekanntmachung des Hinweises auf die Patenterteilung: **21.09.2011**
(21) Anmeldenummer: 05101527.9
(22) Anmeldetag: 01.03.2005
(51) Int. Cl.: H02K 11/00, H02K 19/36, H01L 23/24

(54) **Elektronisches Bauteil mit einer Schaltung, die mit einer Gelschicht versehen ist und Verfahren zur Herstellung des Bauteils**
Electronic device which accommodates an electronic circuit provided with a gel layer and method for producing said device
Dispositif électronique qui contient un circuit électronique pourvu d'une couche de gel et procédé de fabrication de ce dispositif

(30) Priorität: 12.03.2004 DE 102004012600; 15.06.2004 DE 102004028888
(43) Veröffentlichungstag der Anmeldung: 19.10.2005
(73) Patentinhaber: ROBERT BOSCH GMBH, 70442 Stuttgart (DE)
(72) Erfinder: Fischer, Erwin, 71679 Asperg (DE); Reyes Tello, Laura, CF7 8, South Glamorgan (GB); Bachmann, Stefan, 72074 Tuebingen (DE); Holst, Marco, 70197 Stuttgart (DE)

(56) Entgegenhaltungen:
- EP-A- 0 676 450
- EP-A- 1 191 587
- DE-A1- 19 860 035
- JP-A- 61 077 353
- US-A- 5 275 841
- US-B1- 6 614 108

## Beschreibung

Die Erfindung betrifft ein elektronisches Bauteil und ein Verfahren zu dessen Herstellung sowie dessen Verwendung nach dem Oberbegriff der unabhängigen Ansprüche.

### Stand der Technik

Bei elektrischen bzw. elektronischen Bauteilen für Kraftfahrzeuganwendungen ist ein wirksamer Schutz der darin enthaltenen Schaltungselemente insbesondere vor korrosiven Witterungseinflüssen unabdingbar. Aus diesem Grund werden elektronische Bauteile beispielsweise mit Gelen auf der Basis von Polysiloxanen zum Schutz vor korrosiven Umwelteinflüssen versiegelt. Ein Verfahren zur Herstellung derartiger Versiegelungen ist beispielsweise aus der US 6, 210, 749 B1 bekannt. Die dort beschriebenen mehrlagigen Beschichtungen sind elektrisch isolierend und hitzebeständig ausgeführt. Sie umfassen eine erste Schicht auf der Basis eines hydridischen Silsesquioxans und eine weitere Schicht aus Siliziumdioxid. Die Schichtdicke der Beschichtungen beträgt weniger als 3 µm. Weitere Verfahren sind aus US 5,275,841 und EP 1 191 587 bekannt.

Derartige Gelsysteme erfüllen jedoch nicht das Anforderungsprofil von Bauteilen, die sowohl starken dynamischen Belastungen als auch hohen Temperaturdifferenzen ausgesetzt sind. Um Temperaturwechselbeanspruchungen gerecht zu werden, zeigen handelsübliche Gelsysteme meist ein Härtefenster im Penetrationsbereich. Die Penetration ist dabei ein Maß für die Konsistenz bzw. Verformbarkeit des Gelsystems und gibt an, um welche Strecke ein Kegel bestimmter Abmessung senkrecht in das betreffende Gel unter vorgeschriebenen Bedingungen gemäß DIN 51804 eindringt.

Gelsysteme, deren Härte diesem Härtebereich zuzuordnen ist, neigen bei Schüttelbelastungen zu starken Gelbewegungen, die die zu schützende Elektronik (Chips, Bonddrähte) schädigt und speziell bei Bonddrähten zu sogenannten Fersenbrüchen führt. Außerdem zeigen derartige Gelsysteme unbefriedigende Härtestabilitäten bei auftretenden Hochtemperatur-Beanspruchungen. Als Konsequenz können Bauteile mit weichen Gelen, deren Härte im Penetrationsbereich liegt, nicht vollständig mit Gel bedeckt werden oder nur mit einer relativ dünnen Gelschicht überzogen werden. Sie bleiben somit für korrosive Medien angreifbar.

Aufgabe der vorliegenden Erfindung ist es, ein elektronisches Bauteil bereitzustellen, das einen kostengünstigen und wirkungsvollen Schutz gegenüber Umwelteinflüssen auch bei Temperatur- oder Schüttebelastungen aufweist.

### Vorteile der Erfindung

Das erfindungsgemäße Bauteil bzw. das Verfahren zu dessen Herstellung gemäß den kennzeichnenden Merkmalen der unabhängigen Ansprüche hat gegenüber dem Stand der Technik den Vorteil, dass korrosionsempfindliche Bereiche des Bauteils mit einer geeigneten Gelbeschichtung so versiegelt sind, dass eine Einwirkung von Witterungseinflüssen auf die geschützten Bereiche verhindert wird und diese Schutzwirkung auch bei hohen thermischen und mechanischen Belastungen erhalten bleibt. Dies wird erreicht, indem das erfindungsgemäße Bauteil eine Gelschicht aufweist, deren Shore00-Härte in einem Bereich angesiedelt ist, in dem das Gel einerseits keine plastische Verformung unter mechanischen Einflüssen zeigt, andererseits jedoch auch nicht so spröde ist, dass Schüttebelastungen des Bauteils zu Rissen oder Ablösungserscheinungen führen. Dies ist insbesondere in einem Shore00-Härtebereich von 40 bis 48 Punkten der Fall.

Das mit der Gelschicht versehene Bauteil wird sowohl hohen dynamischen Anforderungen als auch Temperaturwechselbelastungen sowie Hochtemperatur- bzw. Tieftemperaturbeanspruchungen gerecht, ohne dass der Korrosionsschutz für korrosionsempfindliche Bauelemente des Bauteils verloren geht. Durch die Einstellung der Gelhärte in einem mittleren Härtebereich wird ein relativ rigides, dreidimensionales Netzwerk erhalten, das gegenüber dynamischen Belastungen, wie sie beispielsweise beim Einsatz elektronischer Reglerbauteile für Generatoren vorkommen, unempfmdlich reagiert und Bonddrahtfersenbrüche bei Bonddrähten mit einem Durchmesser von über 50 Mikrometer vermieden werden. Das Gel ist weiterhin unempfindlich gegenüber üblicherweise im Motorraum vorkommende Medien wie z. B. Öle, Frostschutzmittel, Benzin, Diesel, Kaltreiniger oder salzhaltige Ablagerungen.

Vorteilhafte Weiterbildungen der Erfindung ergeben sich aus den in den Unteransprüchen genannten Maßnahmen.

So ist es vorteilhaft, wenn die Gelschicht auf der Basis eines Polydimethylsiloxans, eines Polyurethans oder eines Epoxidharzes ausgeführt ist, da diese Materialien besonders robust und medienbeständig sind. Besonders geeignet sind Gelsysteme auf der Basis von vinylgruppenmodifizierten Polydimethylsiloxanen.

Ein weiterer besonderer Vorteil der anspruchsgemäßen Gelschicht ist es, dass auch größere Schichtdicken der Gelschicht von mehr als 3 µm realisiert werden können, ohne dass im Dauerbetrieb Risse oder Ablösungserscheinungen auftreten.

In einer besonders vorteilhaften Ausführungsform ist zwischen dem Substrat und der Gelschicht eine Schicht aus einem Haftvermittler vorgesehen, sodass es zu einer besonders stabilen Anbindung der Gelschicht an das zu schützende Substrat kommt. Vorteilhafter Weise wird die Haftvermittlerschicht auf der Basis eines Alkylvinylsiloxans mit Glycidoxy- oder Alkoxyterminierung, eines bifunktionellen Silans wie beispielsweise eines Glycidoxyalkyltrialkoxysilans oder eines silylierten Polyglycols ausgeführt.

### Zeichnung

Ein Ausführungsbeispiel der ErFmdung ist in der Zeichnung dargestellt und in der nachfolgenden Beschreibung näher erläutert. Es zeigt Figur 1 einen Querschnitt durch ein erfindungsgemäßes Bauteil, dessen korrosionsempfindliche Bereiche mit einer Gelschicht geschützt sind, Figur 2 eine Korrelation zwischen der Konzentration des Härters im Gel in Gew.% und der resultierenden Shore00-Härte des ausgehärteten Gels in Abhängigkeit von der Verarbeitungstemperatur, Figur 3 eine Korrelation zwischen der Konzentration des Härters im Gel in Gew.% und der bei einer Messung des ausgehärteten Gels mit einem Texture Analyser aufzuwendenden Kraft in Abhängigkeit von der Verarbeitungstemperatur und Figur 4 eine Korrelation der mittels eines Texture Analyser ermittelten Kraft und der korrespondierenden Shore00-Härte des Gels.

### Ausführungsbeispiel

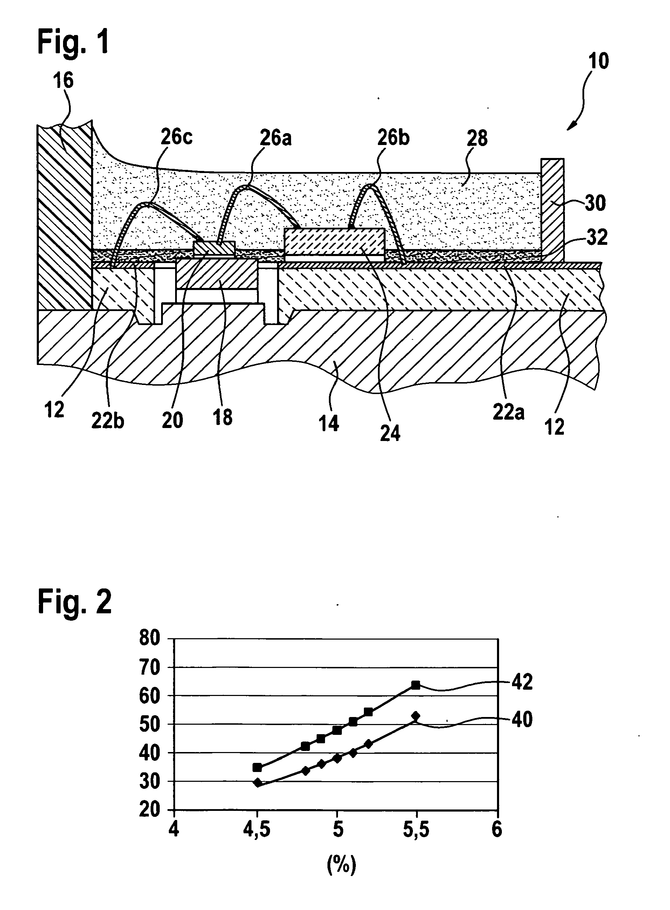

In Figur 1 ist ein erfmdungsgemäßes elektronisches Bauteil in Form eines Reglers 10 gemäß einem ersten Ausführungsbeispiel der vorliegenden Erfmdung dargestellt. Der Regler 10 umfasst ein Substrat 12, das beispielsweise aus einem keramischen Material oder aus einem geeigneten polymeren Werkstoff wie beispielsweise PET ausgeführt ist. Das Substrat 12 ist auf einem Kühlkörper 14 angeordnet, der der Abfuhr entstehender Wärmeenergie dient und aus einem geeigneten, beispielsweise metallischen Material ausgeführt ist. Der Kühlkörper 14 steht in Kontakt mit einem Gehäuse 16, das gleichzeitig als Randbegrenzung des Substrates 12 fungiert. Eine weitere Ausführungsform besteht darin, dass das Substrat 12 Bestandteil des Gehäuses 16 ist.

Auf dem Kühlkörper 14 ist weiterhin, vorzugsweise in einer Durchbrechung des Substrates 12, eine wärmeleitende Schicht 18 vorgesehen, auf der sich eine Schaltung 20, vorzugsweise eine integrierte Schaltung befmdet. Auf dem Substrat 12 sind weiterhin Kontaktbahnen 22a, 22b vorgesehen, die der elektrischen Kontaktierung der elektronischen Bauelemente des Bauteils 10 dienen. Weiterhin ist auf dem Substrat 12 ein Zusatzsubstrat 24 beispielsweise aus einer Aluminiumoxidkeramik angeordnet, das beispielsweise als elektronischer Regler oder mikromechanisches Sensorelement ausgeführt ist. Das mikromechanische Sensorelement kann bspw. als Drucksensor ausgeführt sein. Die Schaltung 20 und das Zusatzsubstrat 24 sind beispielsweise durch einen ersten Bonddraht 26a miteinander kontaktiert. Weiterhin ist das Zusatzsubstrat 24 über einen zweiten Bonddraht 26b mit der Kontaktbahn 22a elektrisch kontaktiert. Die Schaltung 20 ist darüber hinaus mit einem dritten Bonddraht 26c mit der Kontaktbahn 22b verbunden.

Dabei dient die Schaltung 20 beispielsweise der Ansteuerung, Messwerterfassung und -auswertung des elektronischen Bauelements in Form des Zusatzsubstrats 24.

Des Bauteils 10 weist weiterhin eine Gelschicht 28 auf, die das Substrat 12 auf seiner dem Kühlkörper 14 abgewandten Seite zumindest bereichsweise bedeckt. Die Gelschicht 28 wird seitlich durch das Gehäuse 16 sowie einen Überlauf 30 räumlich in ihrer Ausdehnung begrenzt. Die Schichtdicke des Gels ist vorzugsweise so bemessen, dass alle korrosionsempfindlichen elektronischen Bauelemente wie die Schaltung 20 bzw. das Zusatzsubstrat 24 von der Gelschicht 28 umschlossen sind. Gleiches gilt für die Bonddrähte 26a - 26c. Die Gelschicht 28 ist vorzugsweise auf der Basis eines mit Vinylgruppen modifizierten Polydimethylsiloxans ausgeführt. Die Herstellung der Gelschicht 28 erfolgt vorzugsweise so, dass ein Gel auf der Basis eines geeigneten Polysiloxans in die durch das Gehäuse 16, das Substrat 12 und den Überlauf 30 gebildete Kavität eingefüllt wird. Das Gel enthält weiterhin einen geeigneten Härter auf der Basis eines Polysiloxans, das terminale und gegebenenfalls weitere Hydridgruppen aufweist.

Das Gel kann beispielsweise als Zweikomponentensystem ausgeführt sein und folgende beispielhafte Zusammensetzung aufweisen:

| | | |
|---|---|---|
| Komponente A | - Vinylhaltiges Basispolymer | ca. 98 - 99 Gew.% |
| | - Haftvermittler | ca. 1 Gew.% |
| | - Platin-Katalysator (metallorganische Verbindung) | ca. 0.5 Gew.% einer Pt-haltigen Stammlösung |
| | - Inhibitor | < 1 Gew.% |
| | | |
| Komponente B | - Vinylhaltiges Basispolymer | ca. 84 - 94 Gew.% |
| | - Haftvermittler | ca. 1 Gew.% |
| | - Härter | ca. 5 - 15 Gew.% |

Das Gel kann weiterhin Füllstoffe enthalten, wie beispielsweise hochdisperse Kieselsäure als Thixotropierungsmittel oder Silikagel bzw. Aluminiumoxide.

Da die Gelschicht 28 in direktem Kontakt mit elektronischen Bauelementen steht, muss das Gel eine hohe Ionenreinheit insbesondere bezüglich seines Kalium-, Natrium-, Lithium-, Chlorid- oder Bromidgehaltes aufweisen, um Kontaktkorrosion und damit verbundene elektrische Fehler zu vermeiden.

In einem nachgeschalteten Aushärteschritt wird das Gel bei Temperaturen von 120 bis 180 °C in einem Ofen über eine Platin-katalysierte Hydrosilylierungsreaktion vernetzt.

Um eine ausreichend schüttelfeste und temperaturwechselstabile Gelschicht 28 zu erzielen, wird die Konzentration des Härters im Gel so gewählt, dass die resultierende Gelschicht 28 nach der Aushärtung eine Shore00-Härte von 30 bis 50, vorzugsweise von 40 bis 48 Punkten aufweist.

Figur 2 zeigt eine Auftragung der erzielbaren Shore00-Härte des ausgehärteten Gels über der im Gel enthaltenen Härterkonzentration in Gew.%, wenn das Gel eine Stunde bei einer Temperatur von 120 °C ausgehärtet wird (Kurve 40) bzw. wenn das Gel bei einer Temperatur von 150 °C über zwei Stunden ausgehärtet wird (Kurve 42). Dabei wird ersichtlich, dass eine Gelhärte im gewünschten Härtebereich erzielt wird, wenn die Konzentration des Härters im Gel zwischen 4,5 und 5,5, insbesondere zwischen 5,2 und 5,8 Gew.% beträgt und die Aushärtung eine Stunde bei einer Temperatur von 120 °C durchgeführt wird. Wird die Aushärtung über zwei Stunden bei einer Temperatur von 150 °C durchgeführt, so wird die Konzentration des Härters im Gel in einem Bereich von 4,5 bis 5,2, insbesondere in einem Bereich von 4,7 bis 5,2 Gew.% gewählt.

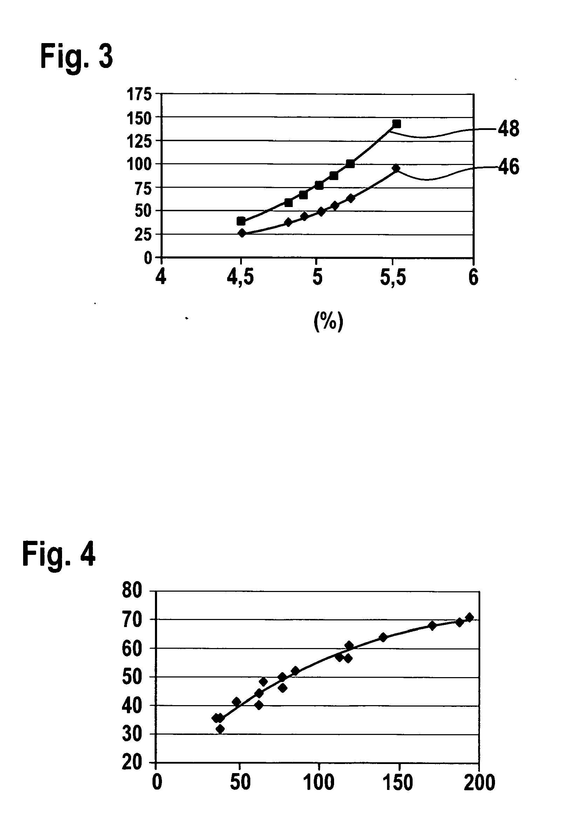

Mittels der in Figur 3 dargestellten Korrelation zwischen der Konzentration an Härter im Gel in Gew.% und der Härte der resultierenden Gelschicht 28, wie sie sich als Kraft über die Messung an einem Texture Analyser ergibt, kann alternativ eine Gelschicht 28 mit einer definierten, mit einem Texture Analyser messbaren Härte eingestellt werden.

Bei der Gelhärtemessung über den Texture Analyser wird die Kraft gemessen, die nötig ist, um einen Probekörper eine bestimmte Distanz in die zu untersuchende Probe eindringen zu lassen. Diese Art der Messung der sogenannten Textur des Probekörpers wird vor allem in der Lebensmittelindustrie eingesetzt und reagiert auf Unterschiede der Probekörper wie z.B. Schichtdickenvarianzen, Form und Material sowie Einflüsse durch Wand- oder Bodeneffekte des Messbehälters sehr sensibel. Zur Vergleichbarkeit der Messungen müssen daher die gleichen Probekörper mit einer einheitlichen Schichtdicke (also Füllmenge) eingesetzt werden.

Die Kurve 46 zeigt analog zu Kurve 40 die erreichbare Härte wenn die Aushärtung des Gels über eine Stunde bei 120 °C durchgeführt wird und Kurve 48 analog zu Kurve 42 die erreichbare Härte, wenn das Gel über zwei Stunden bei einer Temperatur von einer 150 °C ausgehärtet wird. Figur 4 zeigt eine Korrelation der über einen Texture Analyser gewonnenen Härtewerte mit der entsprechenden Shore00-Härte.

Um eine bessere Anbindung der Gelschicht 28 an das Substrat 12 zu erzielen, enthält das verwendete Gel einen Haftvermittler, wobei als Haftvermittler insbesondere Verbindungen geeignet sind, die zum einen eine Alkoxygruppe und andererseits Vinyl-oder Si-H-Gruppen aufweisen, sodass sie den nötigen bifunktionellen Charakter zeigen, um sowohl in das dreidimensionale polymere Siloxannetzwerk der Gelschicht 28 fest eingebunden zu werden und gleichzeitig eine gute Haftung mit den Werkstoffen des Substrates 12 bzw. des Gehäuses 16 oder des Überlaufs 30 aufzuweisen. So sind beispielsweise Alkylvinylsiloxane oder -silane mit Glycidoxy- oder Alkoxyterminierung, Glycidoxypropyltrialkoxysilane, silylierte Polyglycole oder Derrivate dieser Verbindungen als Haftvermittler geeignet. Optional kann das Substrat 12 vor dem Aufbringen der Gelschicht 28 mit einer Haftvermittlerschicht 32 versehen werden.

Die so erzeugte Gelschicht 28 ist für Einsatztemperaturen zwischen - 45 und 150 Grad Celsius geeignet und hält auch dynamischen Belastungen stand, wie sie beispielsweise bei einer Sinusschüttelprüfung im Frequenzbereich von 100 bis 1000 Hz mit einer Amplitude von 0,19 mm und einer maximalen Beschleunigung von 300 m/s² auftreten, sowie auch den Belastungen bei sogenannten Random-Vibration-Untersuchungen mit einer maximalen Beschleunigung von bis zu 800 m/s².

Alternativ können anstelle der beschriebenen Siloxangele auch vorzugsweise transparente Polyurethanvergussmassen oder Epoxidharze eingesetzt werden.

## Patentansprüche

1. Elektronisches Bauteil, insbesondere Regler oder mikromechanisches Sensorelement, mit einem Substrat und einem das Substrat umfassenden Gehäuse sowie einer auf dem Substrat angeordneten Schaltung, wobei zumindest die Schaltung zum Schutz vor Umwelteinflüssen mit einer Gelschicht versehen ist, wobei die Gelschicht (28) eine Shore00-Härte von 30 bis 50 Punkten aufweist, und wobei das Gel der Gelschicht (28) einen Haftvermittler enthält.

2. Bauteil nach Anspruch 1, **dadurch gekennzeichnet, dass** die Gelschicht (28) eine Shore00-Härte von 40 bis 48 Punkten aufweist.

3. Bauteil nach Anspruch 1 oder 2, **dadurch gekennzeichnet, dass** die Gelschicht (28) auf der Basis eines Polydimethylsiloxans, eines Polyurethans oder eines Epoxidharzes ausgeführt ist.

4. Bauteil nach Anspruch 3, **dadurch** gekennzeichet, dass die Gelschicht (28) auf der Basis eines vinylgruppenmodifizierten Polydimethylsiloxans ausgeführt ist.

5. Bauteil nach einem der vorhergehenden Anspruch, **dadurch gekennzeichnet, dass** die Gelschicht (28) eine Schichtdicke von mehr als 3 um aufweist.

6. Bauteil nach Anspruch 6, **dadurch gekennzeichnet, dass** der Haftvermittler ein Alkylvinylsiloxan mit Glycidoxy- oder Alkoxyterminierung, ein Glycidoxyalkyltrialkoxysilan oder ein silyliertes Polyglycol ist.

7. Verfahren zur Herstellung eines elektronischen oder elektrischen Bauteils, insbesondere Regler oder mikromechanisches Sensorelement, mit einem Substrat und einem das Substrat umfassenden Gehäuse sowie einer auf dem Substrat angeordneten Schaltung, wobei zumindest die Schaltung zum Schutz vor Umwelteinflüssen mit einer Gelschicht versehen wird, wobei die Shore00-Härte der Gelschicht über die dem Gel zugesetzte Menge eines Härters auf einen Wert von 30 bis 50 Punkten eingestellt wird, und wobei das Gel der Gelschicht (28) einen Haftvermittler enthält.

8. Verfahren nach Anspruch 8, **dadurch gekennzeichnet, dass** als Gel ein Gel auf der Basis eines Polydimethylsiloxans verwendet wird und als Härter ein hydridisches Polysiloxan verwendet wird.

9. Verfahren nach Anspruch 8 oder 9, **dadurch gekennzeichnet, dass** der Härter in einer Konzentration von 4.2 bis 5.7 Gew.% dem Gel der Gelschicht zugesetzt wird.

10. Verwendung eines Bauteils nach einem der Anspräche 1 bis 7 als Regler für Generatoren oder als mikromechanischer Drucksensor in Kraftfahrzeuganwendungen.

## Claims

1. Electronic component, in particular regulator or micromechanical sensor element, comprising a substrate and a housing encompassing the substrate, and also comprising a circuit arranged on the substrate, wherein at least the circuit is provided with a gel layer for protection against ambient influences, wherein the gel layer (28) has a Shore 00 hardness of 30 to 50 points, and wherein the gel of the gel layer (28) contains an adhesion converter.

2. Component according to Claim 1, **characterized in that** the gel layer (28) has a Shore 00 hardness of 40 to 48 points.

3. Component according to Claim 1 or 2, **characterized in that** the gel layer (28) is embodied on the basis of a polydimethylsiloxane, a polyurethane or an epoxy resin.

4. Component according to Claim 3, **characterized in that** the gel layer (28) is embodied on the basis of a vinyl-group-modified polydimethylsiloxane.

5. Component according to any of the preceding claims, **characterized in that** the gel layer (28) has a layer thickness of more than 3 µm.

6. Component according to Claim 1, **characterized in that** the adhesion promoter is an alkylvinylsiloxane
with glycidoxy or alkoxy termination, a glycidoxyalkyltrialkoxysilane or a silylated polyglycol.

7. Method for producing an electronic or electrical component, in particular regulator or micromechanical sensor element, comprising a substrate and a housing encompassing the substrate, and also comprising a circuit arranged on the substrate, wherein at least the circuit is provided with a gel layer for protection against ambient influences, wherein the Shore 00 hardness of the gel layer is set to a value of 30 to 50 points by way of the amount of a hardener added to the gel, and wherein the gel of the gel layer (28) contains an adhesion promoter.

8. Method according to Claim 7, **characterized in that** a gel based on a polydimethylsiloxane is used as the gel and a hydridic polysiloxane is used as the hardener.

9. Method according to Claim 7 or 8, **characterized in that** the hardener is added to the gel of the gel layer in a concentration of 4.2 to 5.7% by weight.

10. Use of a component according to any of Claims 1 to 6 as a regulator for generators or as a micromechanical pressure sensor in motor vehicle applications.

## Revendications

1. Dispositif électronique, en particulier régulateur ou élément détecteur micromécanique, comportant un substrat et un boîtier entourant le substrat ainsi qu'un circuit disposé sur le substrat, dans lequel au moins le circuit est pourvu d'une couche de gel pour la protection contre les influences ambiantes, dans lequel la couche de gel (28) présente une dureté Shore 00 de 30 à 50 points, et dans lequel le gel de la couche de gel (28) contient un agent adhésif.

2. Dispositif selon la revendication 1, **caractérisé en ce que** la couche de gel (28) présente une dureté Shore 00 de 40 à 48 points.

3. Dispositif selon la revendication 1 ou 2, **caractérisé en ce que** la couche de gel (28) est réalisée à base d'un polydiméthylsiloxane, d'un polyuréthane ou d'une résine époxy.

4. Dispositif selon la revendication 3, **caractérisé en ce que** la couche de gel (28) est réalisée à base d'un polydiméthylsiloxane modifié par un groupe vinyle.

5. Dispositif selon l'une quelconque des revendications précédentes, **caractérisé en ce que** la couche de gel (28) présente une épaisseur de couche de plus de 3 µm.

6. Dispositif selon la revendication 1, **caractérisé en ce que** l'agent adhésif est un alkylvinylsiloxane à terminaison glycidoxy ou alcoxy, un glycidoxyalkyltrialcoxysilane ou un polyglycol silylé.

7. Procédé de fabrication d'un dispositif électronique ou électrique, en particulier d'un régulateur ou d'un élément détecteur micromécanique, comportant un substrat et un boîtier entourant le substrat ainsi qu'un circuit disposé sur le substrat, dans lequel on munit au moins le circuit d'une couche de gel pour la protection contre les influences ambiantes, dans lequel on règle la dureté Shore 00 de la couche de gel à une valeur de 30 à 50 points par la quantité d'un durcisseur ajoutée au gel, et dans lequel le gel de la couche de gel (28) contient un agent adhésif.

8. Procédé selon la revendication 7, **caractérisé en ce que** l'on utilise comme gel un gel à base d'un polydiméthylsiloxane et comme durcisseur un polysiloxane hydruré.

9. Procédé selon la revendication 7 ou 8, **caractérisé en ce que** l'on ajoute le durcisseur en une concentration de 4,2 à 5,7 % en poids du gel de la couche de gel.

10. Utilisation d'un dispositif selon l'une quelconque des revendications 1 à 6 comme régulateur pour des générateurs ou comme détecteur de pression micromécanique dans des applications de véhicule automobile.
